# EUROPEAN PATENT SPECIFICATION

(11) **EP 0 558 100 B1**
(45) Date of publication and mention of the grant of the patent: **04.12.1996**
(21) Application number: 93107043.7
(22) Date of filing: 31.03.1987
(51) Int. Cl.: H01L 29/08, H01L 29/732, H01L 29/737

(54) **Bipolar transistor**
Bipolarer Transistor
Transistor bipolaire

(30) Priority: 01.04.1986 JP 74738/86; 12.05.1986 JP 107936/86; 19.08.1986 JP 193294/86; 01.12.1986 JP 286323/86
(43) Date of publication of application: 01.09.1993
(62) Divisional of application: 87302784.1
(73) Proprietor: MATSUSHITA ELECTRIC INDUSTRIAL CO., LTD., Kadoma-shi, Osaka-fu, 571 (JP)
(72) Inventor: Inada, Masanori, Ikoma-gun, Nara-ken, 636 (JP); Eda, Kazuo, Hirakata-shi, Osaka-fu, 573 (JP); Ota, Yorito, Kobe-shi, Hyogo-ken, 652 (JP); Nakagawa, Atsushi, Kawanishi-shi, Hyogo-ken, 666 (JP); Yanagihara, Manabu, Kadoma-shi, Osaka-fu, 571 (JP)
(74) Representative: Crawford, Andrew Birkby

(56) References cited:
- IEEE ELECTRON DEVICE LETTERS, vol.EDL-3, no.12, December 1982 pages 366 - 368 P.M. ASBECK ET AL.
- JAPANESE JOURNAL OF APPLIED PHYSICS, vol.22, no.22-1, 1983 pages 375 - 380 J.S. HARRIS ET AL.
- GALLIUM ARSENIDE AND RELATED COMPOUNDS 1985, PROCEEDINGS OF THE TWELTH INTERNATIONAL SYMPOSIUM, KARUIZAWA, JAPAN, 23 September 1985 pages 589 - 592 K. NAGATA ET AL.
- IEEE ELECTRON DEVICE LETTERS, vol.EDL-5, no.8, August 1984 pages 310 - 312 P.M. ASBECK ET AL.

## Description

This invention relates to a bipolar transistor which is highly expected as a superhigh-speed, superhigh-frequency device.

Parameters of high speed action, f_{T} and fm, of a bipolar transistor (BT) are expressed as follows.${\text{f}}_{\text{T}} \text{=} \frac{\text{1}}{\text{2π} \left(\text{τe+τb+τc+τcc}\right)}$$\text{fm =} \sqrt{{\text{f}}_{\text{T}}} \text{/} \sqrt{\text{8πRbCbc}}$ where τe (emitter depletion layer charging time) = re (Cbc + Ceb), τb (base transit time) = Wb²/ηD, τc (collector depletion layer transit time) = Wc/2Vs, τcc (collector depletion layer charging time) = (Ree + Rc) Cbc, Rb: base resistance,
Cbc: base-collector capacitance, Ceb: base-emitter capacitance, Wb: base layer thickness, Db: base diffusion coefficient, Wc: collector depletion layer thickness, Vs: collector saturation velocity, re: emitter resistance, Ree: emitter-contact resistance, and Rc: collector resistance.

In the BT, as clear from the formulae above, to increase f_{T} and fm, it is necessary to decrease capacitances of Cbc and Ceb, thickness of base layer, base resistance, emitter resistance, and collector resistance. In particular, to obtain a larger fm, it is required to reduce Rb and Cbc. For these purposes, it is extremely important to reduce the size of each part of BT, optimize the electrode layout, and optimize the process to lower the contact resistance of electrodes, and various attempts are made in these directions.

In the heterojunction bipolar transistor (HBT) using a semiconductor material larger in band gap than the base as the emitter, leak of holes from the base to emitter is restricted (in the case of npn), and it is possible to make the base at high dope, and the emitter and collector at low dope, contrary to an ordinary BT. And it is intrinsically advantageous for reduction of base resistance Rb. Furthermore, in an ordinary BT, Cbc and Ceb are expressed by the product of factors due to doping of junction capacitance and the junction area. In the HBT, since the emitter and collector are at low dope and the base is at high dope, the factors due to doping depend only on the doping of emitter and collector, and Ceb and Ebc are expressed as follows.$\text{Ceb ∝} \sqrt{\text{ne}} \text{· Aeb, Cbc ∝} \sqrt{\text{nc}} \text{· Abc}$

where ne and nc are doping concentrations of emitter and collector, and Aeb and Abc are junction areas of emitter and base, and base and collector, respectively. Therefore, in the HBT, as compared with an ordinary BT, ne and nc can be reduced, so that Ceb and Cbc can be intrinsically reduced. For the high speed operation of HBT, aside from optimization of heterostructure, optimization of device structure and process is important, as mentioned in relation to the BT. In this regard, the following methods have been attempted to reduce Ceb and Cbc. Not only in HBT but also in an ordinary BT, both normal type with the emitter disposed at the upper side and inverted type with the collector disposed at the upper side are possible (H. Kroemer, "Heterostructure Bipolar Transistors and Integrated Circuits," Proc. IEEE, vol. 70, p. 13, 1982). The normal type is advantageous for reducing the emitter size and decreasing Ceb. At the same time, it is possible to decrease Cbc by forming an insulating region in the layer of forming collector by ion implantation from above, and forming a small-size collector of buried type.

In the inverted type BT, since the collector is at the upper side, it is intrinsically advantageous for reducing the collector size and decreasing Cbc. Furthermore, by simultaneous use of ion implantation, it is possible to decrease Ceb by introducing impurities into the layer of forming emitter to form an insulating region, and reducing the emitter size.

Such attempt is made in a normal type HBT (P.M. Asbeck et al., "GaAs/(Ga, Al)As Heterojunction Bipolar Transistors with Buried Oxygen-Implanted Isolation Layers, "Electron Device, Lett., vol. EDL-5, p. 310, 1984).

To reduce the base resistance, attempts are made into a method of reducing the sheet resistance by forming a thick external base region by secondarily introducing the impurities for doping the base in order to lower the external base resistance which occupies a large portion of base resistance (P.M. Asbeck et al., "Application of Thermal Pulse Annealing to Ion-Implanted GaAlAs/GaAs Heterojunction Bipolar Transistors," IEEE Electron Device Lett., vol. EDL-4, P.81, 1983), and into a method of forming the base electrode adjacently to the emitter portion by self-alignment (Nagata et al., "A New Self-aligned Structure AlGaAs/GaAs HBT for High Speed Digital Circuits," Proc. Symp. on GaAs and Related Compounds (Inst. Phys. Conf. Serv. 79), p. 589, 1985).

In the paper "Heterojunction Bipolar Transistors" by Harris et al (Japanese Journal of applied Physics, 22, Supplements 22-1, pages 375-380 [1983]) a bipolar transistor structure is described for application to high speed digital integrated circuits. The described structure comprises a first layer including a collector portion, and a second layer formed on said first layer and including a base portion.

The following problems were involved in conventional methods of making bipolar transistors for high-speed applications. To form a small-sized collector of buried type by ion implantation, a small mask is additionally required. In this case, when the transistor size is smaller, mask matching for formation of this portion and the emitter region is more difficult. Or to form the emitter portion, emitter electrode, and emitter draw-out electrode by different masks presented a problem in mask matching when the transistor size was reduced. In the forming the draw-out electrode, since the emitter, base and collector portions are formed in a mesa pattern, step breakage of draw-out electrode occurred. Besides, when forming an external base portion by ion implantation or by doping at high dose, it is necessary to use different masks for covering the emitter region, and aside from the mask matching of the above portions, mask matching for forming the base electrode and base draw-out electrode became more difficult when the transistor size was smaller. Yet, since it is hard by an ordinary method to form the base electrode adjacently to the emitter, the self-alignment method may be employed, but in the conventional methods mentioned above, since the base electrode was formed before the emitter electrode, if there was limitation in the types of base electrode to be used due to the difference in alloying treatment temperature of these electrodes, mask matching for forming base draw-out electrode and mask matching for forming emitter draw-out electrode were needed, and the process became difficult when the size is reduced, and because of the mesa pattern, step breakage of draw-out electrode and wire disconnection were likely to occur.

According to the present invention there is provided a bipolar transistor comprising a first layer including a collector portion, and a second layer formed on said first layer and including a base portion, wherein
said second layer further includes an insulating portion extending from said base portion, and wherein
said bipolar transistor further comprises;
a third layer, including an emitter portion, formed on a part of said base portion and extending to cover a part of said insulating portion of said second layer; and
an emitter electrode layer formed to cover an entire upper surface of said third layer wherein a part of said emitter electrode layer on a part of said third layer covering a part of said insulating portion of said second layer serves as an emitter electrode contact lead.

According to another aspect of the present invention there is provided a bipolar transistor comprising a first layer including an emitter portion, and a second layer formed on said first layer and including a base portion,
wherein said second layer further includes an insulating portion extending from said base portion, and
wherein said bipolar transistor further comprises:
   a third layer, including a collector portion, formed on a part of said base portion and extending to cover a part of said insulating portion of said second layer; and
   a collector electrode layer formed to cover an entire upper surface of said third layer wherein a part of said collector electrode layer on a part of said third layer covering a part of said insulating portion of said second layer serves as a collector electrode contact lead.

The transistors according to the above two aspects of the present invention are essentially equivalent to each other, the positions of the collector and emitter in those according to the first aspect being reversed in those according to the second aspect. Transistors according to either aspect may be formed by a method according to copending European Patent Application No. 87302784.

The invention will now be described in more detail by way of example, with reference to the drawings in which:
Fig. 1 shows an example of structure of a bipolar transistor according to this invention, in which (a) is a front sectional view, (b) is a side sectional view, and (c) is a layout plan of parts;
Fig. 2 is a sectional view showing the relation of the emitter electrode metal layer and a thick external base region formed by self-alignment of a bipolar transistor according to this invention;
Figs. 3, 4, 5 are sectional views showing the configuration of emitter electrode metal layer, emitter portion and base electrode metal layer of a bipolar transistor according to this invention;

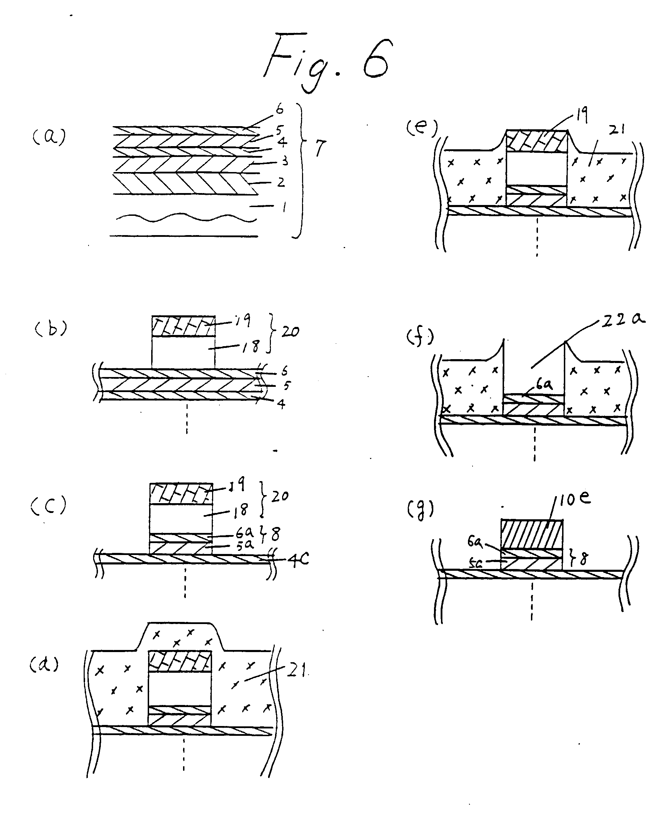

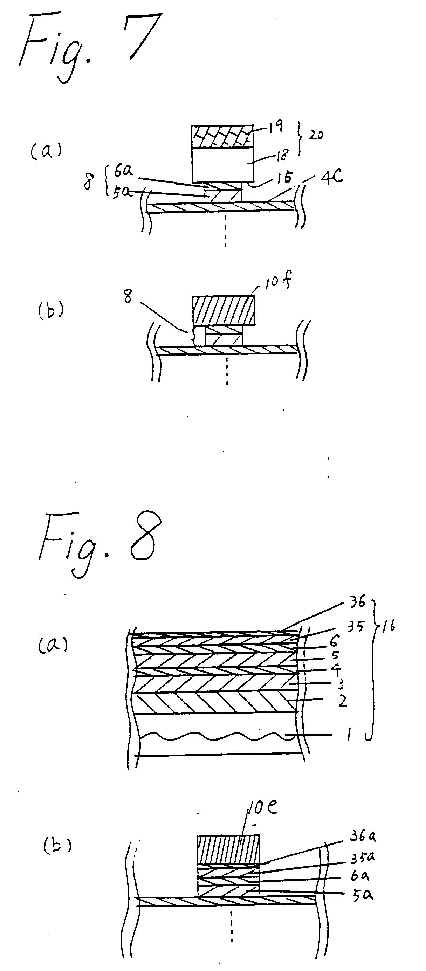

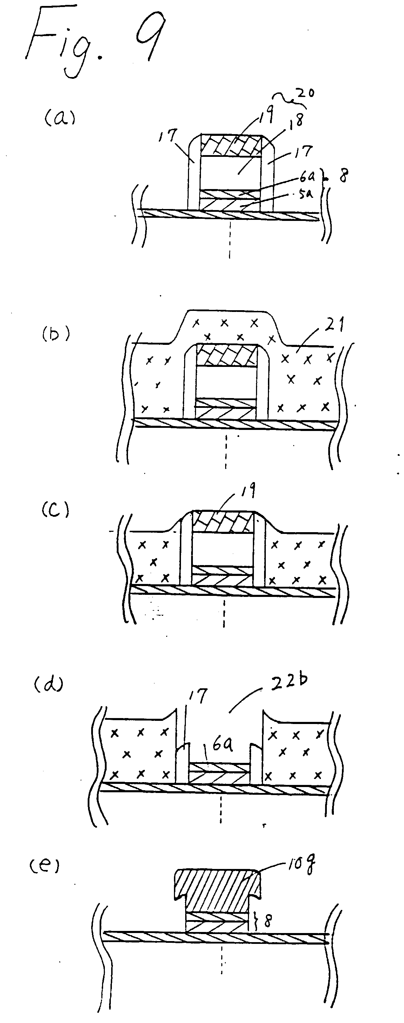

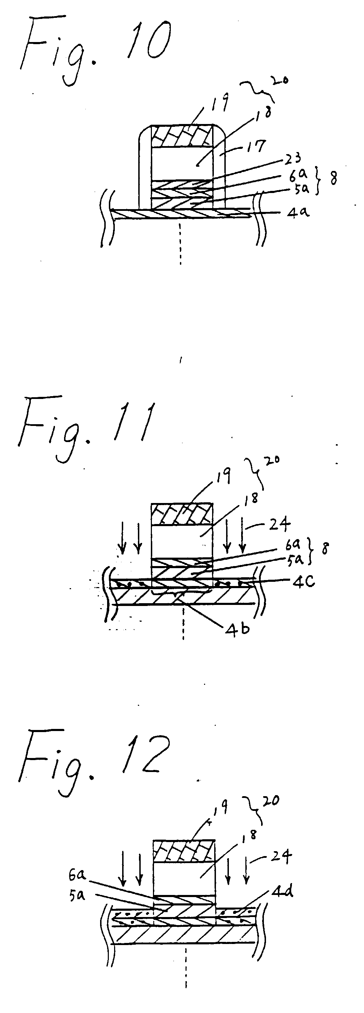

Figs. 6, 7, 8, 9, 10 are sectional view indicating the method of forming the emitter electrode metal layer by inverting from dummy emitter, in which Fig. 6 relates to a case of covering the entire upper surface of emitter, with the emitter electrode metal layer substantially same in size as the emitter, Fig. 7 shows the emitter electrode metal layer covering the upper surface of the emitter in a form of an umbrella, Fig. 8 refers to a case of placing a semiconductor material layer greater in the work function than the electrode metal, between the emitter electrode metal layer and emitter in Fig. 6, Fig. 9 denotes a case of placing the emitter electrode metal layer on the emitter to cover its upper surface in a mushroom shape, and Fig. 10 shows a case of using AlₓGa₁₋ₓ AS (x = 0.4) as protective film of emitter-contact layer in the process in Fig. 9;
Fig. 11, 12 are sectional views showing the method of forming a low resistance external base region using dummy emitter and mask, by self-alignment, by ion implantation, in which Fig. 11 shows a case of forming a high dope external base region and Fig. 12 refers to a case of forming a thick external base region;
Fig. 13 denotes a method of forming a buried type collector region, by self-alignment, by ion implantation, using dummy emitter as mask;
Fig. 14 shows a method of forming, by self-alignment, a buried type collector region by ion implantation, using emitter electrode metal layer as mask;

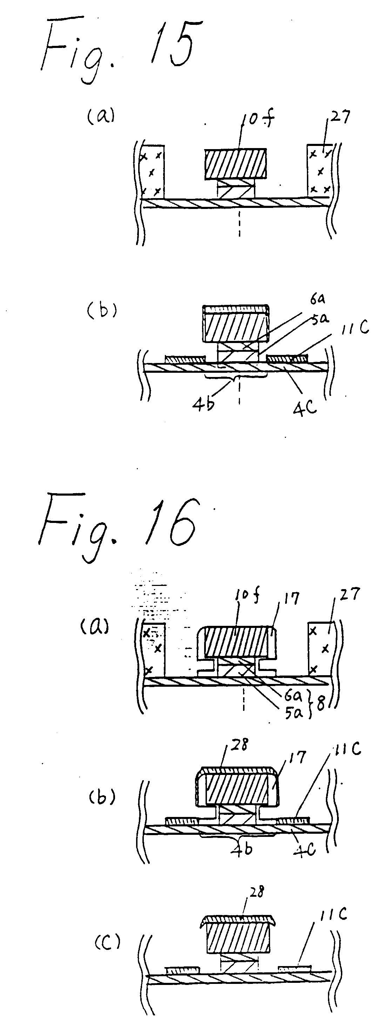

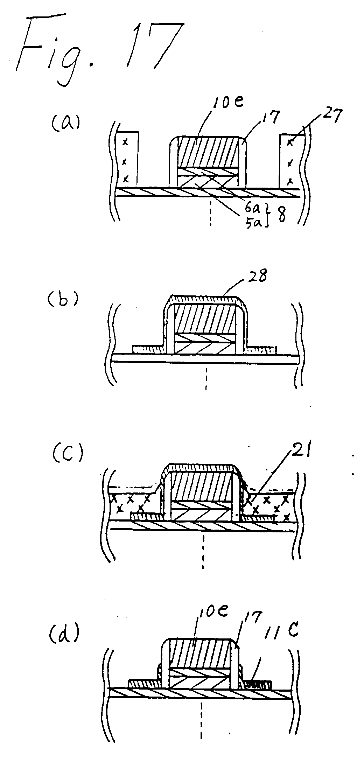

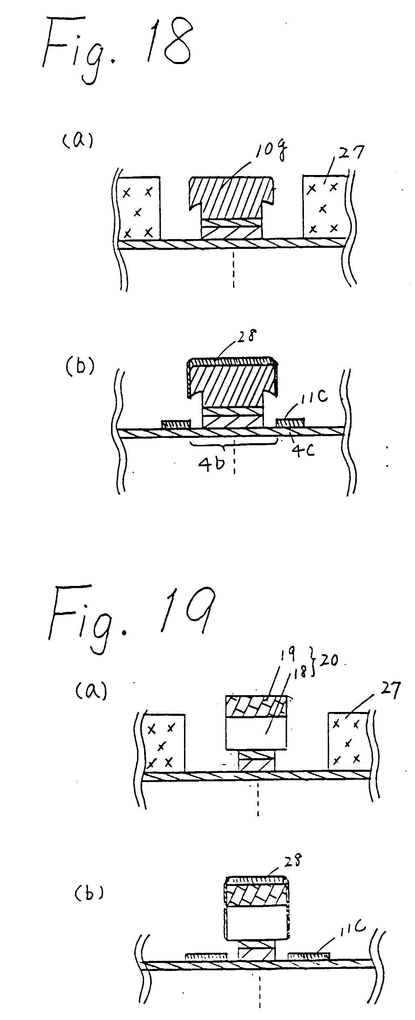

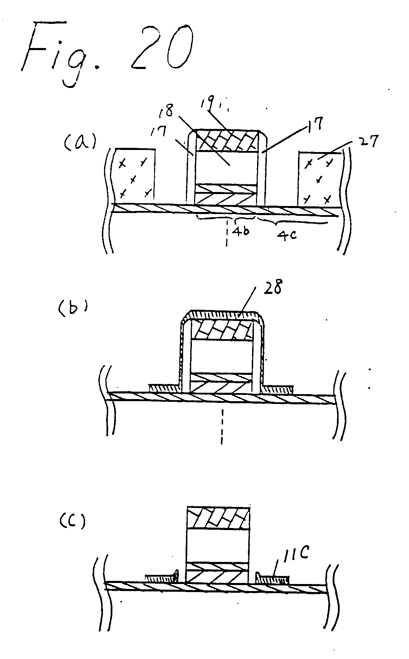

Figs. 15, 16, 17, 18, 19, 20 represent methods of forming base electrode metal layer, by using emitter electrode metal layer or dummy emitter, by self-alignment, adjacently to the emitter portion, in which Fig. 15 is a method of using an umbrella-shaped emitter electrode metal layer as mask, Fig. 16 is a method of using emitter electrode metal layer and SiOₓ side wall formed at its side as mask, Fig. 17 is a method of using SiOₓ side wall by using an emitter electrode metal layer covering the upper surface of emitter portion in the same size, Fig. 18 is a method of using a mushroom-shaped emitter electrode metal layer, Fig. 19 is a method of forming emitter electrode metal layer after forming, by self-alignment, a base electrode layer using umbrella-shaped dummy emitter, and Fig. 20 is a method of forming an emitter electrode metal layer after forming a base electrode metal layer by self-alignment, using a dummy emitter substantially of the same size as the emitter;
Fig. 21 shows a self-alignment forming method of a coupled projection of emitter region and an insulating region formed by transforming from the emitter material, and an emitter electrode metal layer to cover the entire surface of the top of this projection; and
Fig. 22 shows a forming method of base electrode metal layer positioned adjacently to the emitter portion, extending from the outer base region to the insulating region around the transistor, by using the emitter electrode metal layer in Fig. 21.

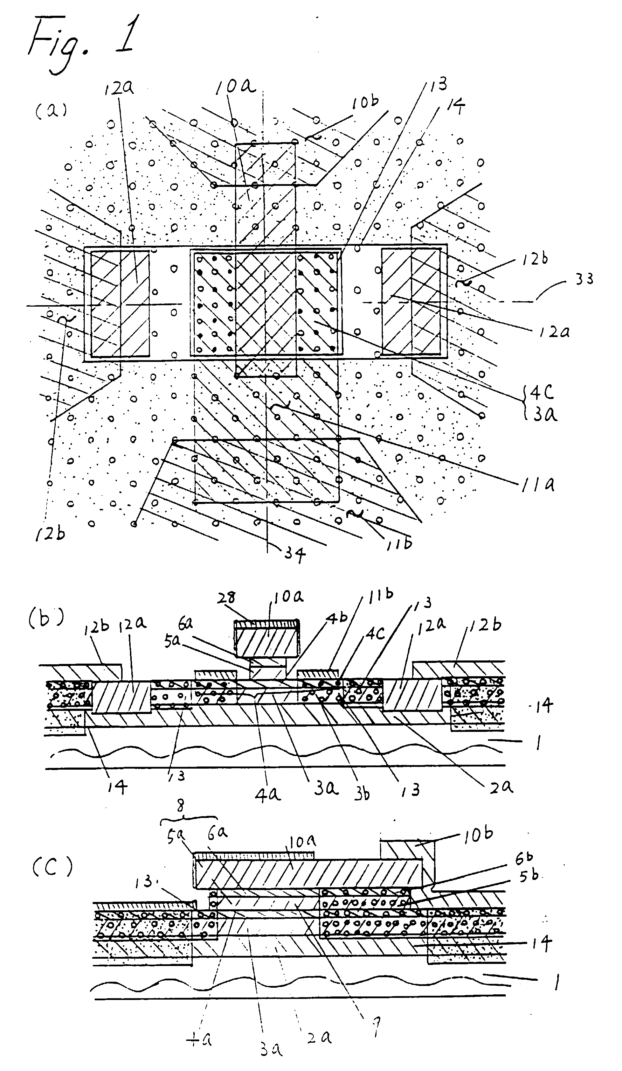

In Figs. 1 to 22, the reference numbers are meant as follows:

1--semi-insulating GaAs substrate, 2--high dope n-type GaAs, 2a--part of 2 to compose a bipolar transistor, 3--n-type GaAs, 3a--collector region, 3b--insulation region formed by transforming from material of 3, 4--high dope p-type GaAs, 4a--part of 4 to compose a bipolar transistor, 4b--base region just beneath emitter electrode metal layer or the layer composed of it and side wall, 4c--base region of outside of 4b, 4d--thick outer base region, 5--n-type AlₓGA₁₋ₓAs, 5a--part of 5 to compose a bipolar transistor, 5b--insulating region formed by transforming from the material of 5, 5c--p-type region formed by transforming from the material of 5, 6--high dope n-type GaAs, 6a--part of 6 to compose a bipolar transistor, 6b--insulating region formed by transforming from the material of 6, 7--multilayer structural material composed of parts 1 to 7, 8--emitter region composed of 5a and 6a, 9--projection composed of 8 and 5b, 6b, 10a--emitter electrode metal layer covering the whole upper surface of projection 9 in a form of umbrella, 10b--wiring pattern of emitter electrode, 10c--emitter electrode metal layer covering the whole upper surface of projection 9, having substantially same size as projection 9, 10d--mushroom-shaped emitter electrode metal layer to cover the upper surface of projection 9, 10e--emitter electrode metal layer covering the whole upper surface of emitter, having substantially same size as emitter, 10f--emitter electrode metal layer to cover the whole upper surface of emitter in a form of umbrella, 10g--mushroom-shaped emitter electrode metal layer to cover the whole upper surface of emitter, 11a--base electrode metal layer extending from outer base region to peripheral insulating region, 11b--base electrode wiring pattern, 11c--base electrode formed adjacently to emitter portion, 12a--collector electrode, 12b--collector electrode wiring pattern, 13--insulating region inside transistor, 14--external insulating region externally contacting with transistor, 15--undercut portion by etching, 16--multilayer structural material composed of 7, 35 and 36, 17--side wall, 18⁻⁻SiOₓ dummy emitter, 19--Al dummy emitter, 20--dummy emitter, 21--photosensitive resin, 22a--opening with exposed 6a, 22b--umbrella-shaped opening with exposed 6b, 23--AlₓGa₁₋ₓAs (x ≧ 0.4) to protect layer 6, 24--ion implantation (Be⁺), 25--ion implantation (O⁺), 26--ion implantation (H⁺), 27--mask of photosensitive resin, 28--base electrode metal, 29a--base region, 29b--mask in same size as base region, 30--SiOₓ dummy emitter extending from emitter region to insulating region, 31--Al dummy emitter to cover the whole upper surface of 30, 32--dummy emitter composed of 30 and 31, 33--cross section of bipolar transistor, 34--cross section of bipolar transistor, 35--n-type InₓGa₁₋ₓAs (x = 0 to 1), 35a--part of 35 formed on emitter portion 8, 36--n-type InAs layer, and 36--part of 36 formed on emitter 8.

### Embodiment 1

Fig. 1 shows an npn type heterojunction bipolar transistor (HBT), as an example of structure of bipolar transistor (BT) according to a first embodiment of this invention. Fig. 1 (a) is a conceptual drawing showing a plan view of the configuration of components of HBT, and Fig. 1 (b) is a sectional view cutting Fig. 1 (a) on a plane 33 perpendicular to the paper surface, while Fig. 1 (c) is a sectional view cutting Fig. 1 (a) on a plane 34 perpendicular to the paper surface.

On the circumference of base region 4a composed of high dope p-type GaAs (p⁺-GaAs), there are insulating region 13 formed by transforming from the p⁺-GaAs and GaAs (n-GaAs) doped in n-type to form collector region 3a, and insulating region 14 formed by transforming from high dope n-type GaAs (n⁺-GaAs) layer to form the contact for collector 2a in addition to semiconductor materials of 4a and 3a.

The emitter region 8 is composed of part 5a made of n-type AlₓGa₁₋ₓAs (n-AlGaAs) with a large band gap, and part 6a made of n⁺-GaAs, and forms the portion of projection 9 coupled with an insulating region composed of 6b and 5b formed by transforming from the semiconductor materials of 6a and 5a.

The emitter electrode metal layer 10a covers the whole upper surface of said projection 9, and has a structure of projecting like an umbrella around the projection 9, and this structure serves both as emitter electrode and as emitter draw-out electrode.

Accordingly, the resistance of emitter contact is extremely small as compared with that of the conventional HBT. Besides, the wiring pattern 10b can be formed very easily by using a simple mask, and this wiring pattern 10b is also free from wire disconnection due to step breakage, which was a conventional problem, because it contacts with the emitter electrode metal layer 10a on three sides. Moreover, since the emitter electrode metal layer 10a serves both as emitter electrode and as emitter draw-out electrode, the HBT of an extremely small emitter size may be easily fabricated. Part 6b of projection 9 is insulated in this embodiment, but it is not necessarily required. If the part 6b is left in a state of n⁺-GaAs, the capacitance in the insulating region 14 enclosed between electrode metal layer 10a and n⁺-GaAs layer 2 is slightly increased, but this change is negligibly small in an HBT of small size. To the contrary, since the forming area of contact of emitter is widened, it is effective to reduce the contact resistance. Similarly, as for part 5b, the upper surface may be also in n-type state.

The base electrode metal layer lla is coupled with the base region 4b just beneath the umbrella-shaped emitter electrode metal layer 10a, and is extended from the external base region 4c to peripheral insulating region 14, working both as base electrode and as base draw-out electrode. Accordingly, formation of base wiring pattern is extremely easy, and since there is no step difference, wire disconnection due to step breakage does not occur. Incidentally, since the electrode layer 11a is formed very closely to the emitter part 5a, the external base resistance is extremely reduced.

Just beneath the emitter electrode metal layer 10a, a buried type collector 3a substantially of a same size as the emitter electrode portion is formed, together with an insulating region 3b formed by transforming from the same semiconductor material as 3a, on its periphery. Hence, the base-collector junction capacitance Cbc can be extremely decreased.

The base region 4c outside of the base region 4b just beneath the emitter electrode is of p-type with higher dope than the base region 4b. Accordingly, the external base region possesses a small sheet resistance.

In this embodiment, the HBT comprehensively possessing the features of the parts mentioned above is formed.

In said structure of HBT, AlₓGa₁₋ₓAs is used as emitter, and GaAs is used to form other parts, but the same structure may be also applicable to HBT made of other materials, or usual homojunction BT composed of emitter, base and collector of same semiconductor material, or pnp type BT. Moreover, it may be also applied to inverted type HBT or BT in which the positions of emitter and collector are exchanged so that the collector comes to the upper side.

In Fig. 1, the structure of HBT comprises all of said emitter, emitter electrode metal layer, base electrode metal layer, buried type collector, and low resistance external base, but this is not limitative. For example, the HBT of enhanced performance as compared with the conventional product may be presented by using characteristic projection 9 and emitter electrode metal layer 10a and forming the other parts in the ordinary HBT construction, or by combining it with other characteristic structure mentioned above.

### Embodiment 2

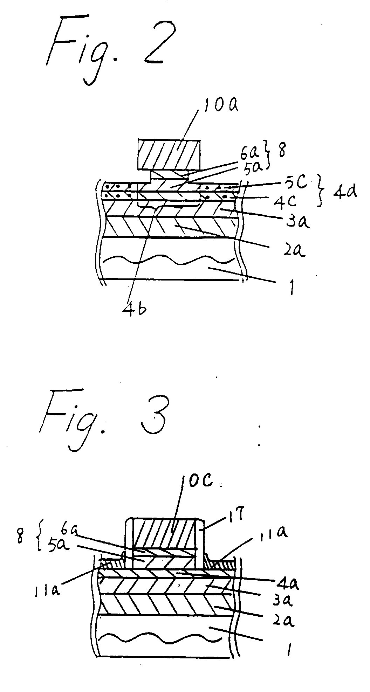

Fig. 2 shows a different structure of the first embodiment, wherein the base region 4d outside of the base region 4b just beneath the emitter electrode metal layer 10a is a thick external base region composed of p-type region 5c formed by transforming from the same semiconductor material as emitter region 5a and external base region 4c of p⁺-GaAs.

As a result, the sheet resistance of external base may be reduced. It does not matter at all if the external base region extends to the portion of collector layer 3a, and it is contrarily effective to lower the sheet resistance of external base.

### Embodiment 3

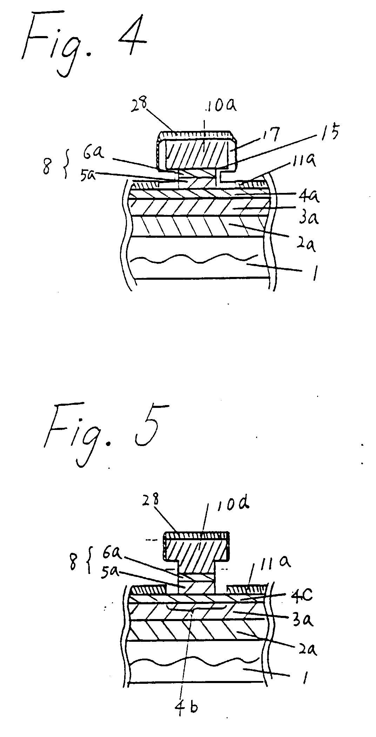

Fig. 3 shows another structure of emitter electrode metal layer 10a and base electrode metal layer lla in the first embodiment.

In Fig. 3, relating to the first embodiment, the whole upper surface of emitter projection 9 is covered by the emitter electrode metal layer 10a of substantially same size therewith, a side wall 17 made of Si0ₓ thin film of 300nm (3000Å) in thickness is formed on the sides around the projection 9 and emitter electrode metal layer 10a, and an electrode metal layer lla is formed substantially in contact with the side wall 17, extending from the external base to the peripheral insulating region. The effect is same as mentioned in the first embodiment. As the side wall, meanwhile, other insulating material may be used, such as SiNₓ.

### Embodiment 4

Fig. 4 shows a further different composition of the first embodiment, in which a side wall 17 made of thin film of SiOₓ in 300nm (3000Å) in thickness is formed on the side of emitter projection 9 and emitter electrode metal layer 10a, and an electrode metal layer lla is formed substantially in contact with the side wall 17, extending from the external base to the peripheral insulating region 14. As the side wall, other insulating material such as SiNₓ may be also used.

### Embodiment 5

Fig. 5, also relating to the first embodiment, shows a structure in which the whole upper surface of projection 9 is covered with emitter electrode metal layer, and the electrode metal layer itself is shaped like a mushroom, spreading to the peripheral parts of the projection 9, and in connection with the base region 4b just beneath the mushroom electrode, there is a base electrode metal layer 11a extending from the external base region 4c to the peripheral insulating region 14.

### Embodiment 6

Fig. 6 illustrates a method of fabrication by forming an emitter electrode metal layer 10e to cover the whole upper surface of projection 8 composed of emitter region. As shown in Fig. 6 (a), on a semi-insulating GaAs substrate 1, a multilayer structural material 7 composed of n⁺-GaAs layer 2, n-GaAs layer 3, p⁺-GaAs layer 4, n-AlGaAs layer 5, and n⁺-GaAs layer 6 is formed by epitaxial growth.

On this multilayer structural material 7, a 1 µm thick SiOₓ thin film is formed, and in the portion corresponding to emitter on this film, an Al layer 19 of 500nm (5000Å) in thickness is formed by evaporating and lifting off, and SiOₓ layer 18 corresponding to emitter portion is formed by dry etching with CHF₃, using the Al layer 19 as mask (Fig. 6 [b]). By exposing the external base region 4c by etching, using a dummy emitter 20 composed of SiOₓ layer 18 and Al layer 19 as mask, and a protruding emitter region 8 is formed (Fig. 6 [c]). In succession, the surface is covered and flattened with photosensitive resin 21 (Fig. 6 [d]), and the photosensitive resin 21 is etched by dry etching using oxygen plasma, and the upper part of dummy emitter 20 is exposed (Fig. 6 [e]), then, removing the Al layer 19 by hydrochloric acid and also removing SiOₓ 18 by buffer HF, an opening 22a is formed (Fig. 6 [f]). Next, in this opening 22a, AuGe, Ni, Ti and Au are evaporated in this order and etching (Fig. 7 [a]), and thereafter, using the process of (d) through (g) in Fig. 6, and lifted off, and an emitter electrode metal layer 10e is formed (Fig. 6 (g)). As a result, the emitter electrode metal layer 10e to cover the whole upper surface of emitter region 8 is formed. In this embodiment, meanwhile, as the layer to form dummy emitter, SiOₓ layer and Al layer are used, but instead of SiOₓ, other materials such as SiNₓ may be also used. Or, instead of Al, other metal may be used, too. Incidentally, after forming SiOₓ 18 by dry etching, the Al layer 19 is not necessarily required. In this embodiment, the external base region 4c can be made also by etching until close to the external base region using a dummy emitter 20 as a mask, and then by etching up to the external base region using the emitter electrode metal layer as a mask. This has an effect to protect the external base region from being damaged during the process. This process can be applied also to homojunction BT, or HBT or BT of inverted type.

### Embodiment 7

Fig. 7, relating to the embodiment formed by the method of Fig. 6, shows a different structure, in which, after forming dummy emitter 20 as in Fig. 6(b), wet etching is carried out to expose the external base region 4c as shown in Fig. 7(a), and an undercut portion 15 is formed beneath the dummy emitter 20 by etching (Fig. 7(a)), and thereafter, using the process of (d) through (g) in Fig. 6, an emitter electrode metal layer 10f to cover the emitter projection 8 in a form of umbrella as shown in fig. 7 (b) is formed, using dummy emitter 20.

### Embodiment 8

By forming a multilayer structural material 16 by epitaxial growth of high dope n-type InₓGa₁₋ₓAs layer 35 in which x carries continuously from 0 to 1 (n-InₓGa₁₋ₓAs (x = 0 to 1) and high dope n-type InAs layer 36 on multilayer structure material 7, an emitter electrode metal layer 10e is formed as shown in Fig. 8 (b) by applying the method of Fig. 6. Since the work function of InAs is greater than that of electrode metal, a low resistance emitter contact may be obtained without any alloying heat treatment. In the embodiment, InₓGa₁₋ₓAs continuously varying in composition and InAs are formed in layers, but InₓGa₁₋ₓ As of a specific composition may be also formed in a layer. 9.

### Embodiment 9

Fig. 9 shows a fabricating method of mushroom-shaped emitter electrode metal layer 10g. After forming an emitter projection 8 by etching as shown in Fig. 6 (c), using dummy emitter 20 as mask, the surface is covered with a thin film of Si0ₓ of 300nm (3000Å) in thickness, and a side wall 17 composed of Si0ₓ is formed on the sides of emitter projection 8 and dummy emitter 20 by anisotropic dry etching using CHF₃ (Fig. 9 (a)). Then the surface is coated and flattened with a photosensitive resin 21 (Fig. 9 (b)), and the upper part of the dummy emitter 20 is exposed by dry etching using oxygen plasma (Fig. 9 (c)), and after removing Al 19 by HCl, an opening 22b with n⁺-GaAs layer 6a exposed is formed by anisotropic dry etching using CHF₃ (Fig. 9 (d)). In succession, AuGe, Ni, Ti and Au are evaporated in this order and lifted off, thereby forming an emitter electrode metal layer 10g.

Emb. 10 By forming an AlₓGa₁₋ₓAs layer 23 where x is 0.4 or more on the multilayer structural material in Fig. 6 (a), the process of Fig. 9 is applied thereafter. However, in the process of Fig. 9 (d), after removing SiOₓ layer 18 and also removing AlₓGa₁₋ₓAs layer 23 by using acid, the emitter electrode metal layer 10g is formed. By this method, damage of n⁺-GaAs layer 6a by dry etching may be prevented, and a clean n⁺-GaAs layer 6a appears, so that an ohmic contact of high quality may be obtained. This method may be also applied in the embodiments formed by the methods of Figs. 6 to 8.

Emb. 11 Fig. 11 shows a method of forming an external base region 4c of high dope p-type, by ion implantation of p-type dopant into the external base region 4c outside of the base region 4b just beneath the emitter electrode, using dummy emitter as mask. After forming the structure of (c) in Fig. 6, Be⁺ is implanted using the dummy emitter 20 as mask (24), and it is heated to 750°C for 10 seconds, so that a high dose external base region 4c as shown in Fig. 11 is formed. Thereafter, applying the method of Fig. 6, the dummy emitter 20 is inverted to an emitter electrode metal layer 10e.

After ion implantation, it is necessary to anneal at a relatively high temperature, but adverse effects are not present because the n⁺-GaAs layer 6 is covered with SiOₓ layer 18. Otherwise, Be⁺ may be implanted at the step of Fig. 6 (b), or after etching until close to the external base region 4c, and then the external base may be exposed by etching. Or the implanted Be⁺ may penetrate even into the collector region 3a. For this purpose, aside from Be⁺, Mg⁺ or Zn⁺ may be also used.

Emb. 12 As shown in Fig. 12, after forming a dummy emitter 20 as in Fig. 6 (b), Be⁺ is implanted, and part of GaAs layer 6 and AlₓGa₁₋ₓAs layer 5 is etched off, and a thick external base region 4d is formed, so that the sheet resistance may be lowered. Thereafter, by applying the method shown in Fig. 6, the dummy emitter 20 is changed into an emitter electrode metal layer 10e.

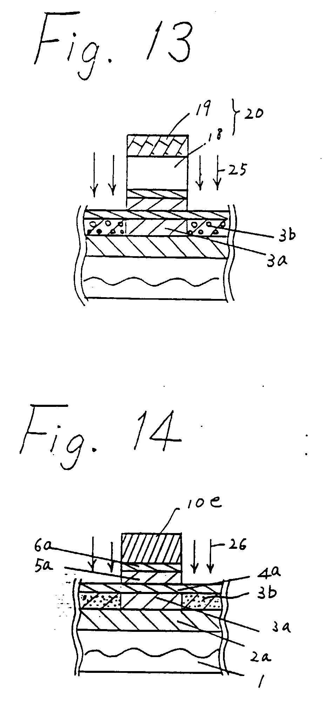

Emb. 13 Fig. 13 shows a method of forming a buried type collector 3a of the same size as dummy emitter by ion implantation, using the dummy emitter 20 as mask. After the step in Fig. 6 (c), a collector 3 substantially of same size as dummy emitter 20 and its peripheral insulating region 3b are formed by implanting O⁺ ions into the layer 3 in which the collector is to be formed using the dummy emitter as mask as shown in Fig. 13, and, by heat treatment at 750°C for 10 seconds. Thereafter, by employing the method shown, in Fig. 6, the dummy emitter 20 is inverted into an emitter electrode metal layer 10e. Aside from O⁺, other ions such as B⁺ may be used. Same as in the embodiments formed by the methods of Figs 11 and 12, heat treatment at high temperature is enabled owing to the existence of SiOₓ dummy emitter.

Emb. 14 After forming an emitter electrode metal layer 10e (Fig. 6 (g)), the collector region 3a substantially of same size as the emitter electrode metal layer and its peripheral insulating region 3b are formed by implanting H⁺ ions are implanted into a layer 3 for forming a collector, as shown in Fig. 14, using the emitter electrode metal layer 10e as mask. In the case of H⁺ ion implantation, since heat treatment is not needed in formation of insulating region, the contact part formed between the emitter electrode metal layer 10e and emitter is protected from damage. Hence, it is possible to form a buried type collector region 3a by using H⁺.

Emb. 15 After forming an umbrella-shaped emitter electrode metal layer 10f as shown in Fig. 7 (b), a base electrode metal 28 is evaporated and lifted off, using photosensitive resion 27 and electrode metal layer 10f as mask as shown in Fig. 15 (a), and the base electrode metal layer 11c is coupled with the base region 4b just beneath the electrode metal layer 10a, thereby forming a base electrode 11c in the external base region 4c. As a result, the base electrode 11c is formed by self-alignment at an extremely close distance from the emitter 5a, and the base resistance may be notably reduced.

Emb. 16 After forming an umbrella-shaped emitter electrode metal layer 10f as shown in Fig. 7 (b), the surface is coated with a thin film of SiOₓ in a thickness of 300mm (3000Å),and by anisotropic dry etching using CHF₃, SiOₓ side wall 17 is formed on the sides around emitter projection 8 and electrode metal layer 10f as shown in Fig. 16 (a). Furthermore, as shown in Fig. 16 (b), a base electrode metal 28 is evaporated and lifted off by using photosensitive resion 27 and umbrella-shaped portion composed of electrode metal layer 10f and side wall 17 as mask. This forms the base electrode metal layer 11c in the external base region 4c, coupled with the base region 4b just beneath the electrode metal layer 10f and side wall 17, as shown in Fig. 16 (b). Then the SiOₓ side wall 17 is removed by buffer HF. As a result, even if the base electrode metal 28 deposits on the side of metal 28, shorting is prevented, and hence the reliability of process is remarkably improved. Hence, the same effect as in the embodiment of Fig. 15 is obtained.

Emb. 17 After forming an emitter electrode metal layer 10e (Fig. 6 (g)), SiOₓ side wall 17 is formed on the sides around emitter projection 8 and metal layer 10e, and a mask 27 of photosensitive resin is applied as shown in Fig. 17 (a). In succession, base electrode metal 28 is evaporated and lifted off, and a structure shown in Fig. 17 (b) is formed. Then, the surface is covered with photosensitive resist 21, and the upper surface of electrode metal layer 10e is exposed by dry etching using oxygen plasma as shown in Fig. 17 (c). By etching away the metal 28 depositing on the side wall 17, the emitter electrode and base electrode are separated. As a result, as a shown in Fig. 17 (d), the base electrode metal layer 11c is formed at a distance of the width of side wall 17 with respect to emitter part 5a. Hence, the external base resistance may be reduced.

Emb. 18 After forming a mushroom-shaped emitter electrode metal layer 10g as shown in Fig. 9 (e), a mask 27 of photosensitive resin is formed as shown in Fig. 18 (a), and a base electrode metal 28 is evaporated and lifted off by using this mask 27 and also metal electrode layer 10g as mask. Consequently, a base electrode metal layer 11c is formed on the external base region 4c in conjunction with the base region 4b just beneath the electrode metal layer 10g. As a result, the external base resistance can be reduced.

Emb. 19 In succession to Fig. 7 (a), a base electrode metal 28 is evaporated and lifted off by using photosensitive resion 27 and dummy emitter 20 as mask as shown in Fig. 19 (a). Consequently, a base electrode metal layer 11c is formed as shown in Fig. 11 (b). Next, using the process of changing the dummy emitter 20 into emitter electrode metal layer shown in embodiment 6, a structure corresponding to Fig. 15 (b) is formed. As a result, the base electrode metal layer 11c is formed adjacently to the emitter 5a, and the base resistance may be lowered. In this method, incidentally, since the base electrode is formed first, it is important that the contact between the base electrode metal and external base is free from damage at the forming temperature of ohmic contact of emitter. In this embodiment, as the material for base electrode metal, for example, Cr/Au and Cr/AuZn/Au may be used.

Emb. 20 In the formation of structure in Fig. 9 (a), a side wall composed of SiNₓ is formed as side wall 17, in a similar method as shown in Fig. 20 (a), and a base electrode metal 28 is evaporated and lifted off through the mask 27 of photosensitive resin as shown in Fig. 20 (b). Thereafter, applying the method of separation of base electrode from emitter electrode shown in the embodiment of Fig 17,and selectively removing SiNₓ with respect to the dummy emitter 19, a structure of Fig. 20 (c) is formed. Then, conforming to the process of changing the dummy emitter into emitter electrode metal layer shown in embodiment 6, the base electrode metal layer 11c is formed adjacently to the emitter part 5a. Same as in the embodiment of Fig.19, it is necessary to select a metal, as base electrode metal, of which ohmic contact forming temperature is not lower than the ohmic contact forming temperature of emitter. In this embodiment, the external base region 4c can be exposed also by etching until close to the region 4c before forming the side wall 17, and then by etching up to the region 4c.

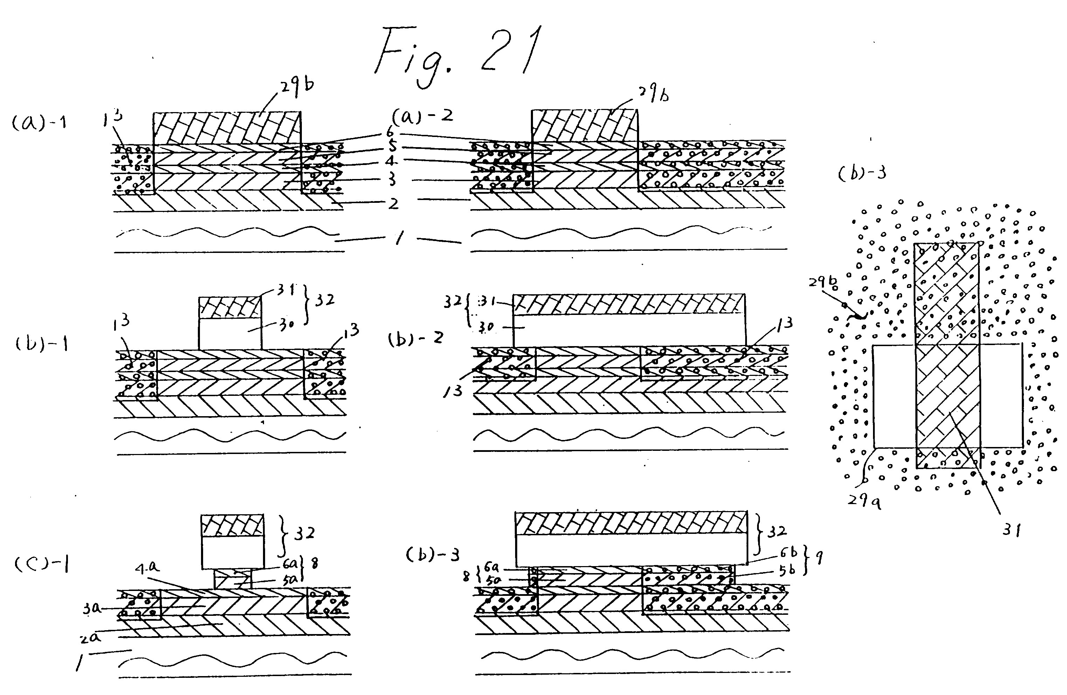

Emb. 21 Fig. 21 shows a method of forming an emitter projection shown in Fig. 1 and an electrode, metal layer 10a serving both as emitter electrode and as draw-out electrode. On the multilayer structural material 7 shown in Fig. 6, a mask 29b corresponding to the size 29a of the base is formed as shown in Fig. 21 (a), and O⁺ ions are implanted into the layer 3 for forming the collector. Consequently, an insulating region 13 is formed. Then, on the portion 29a corresponding to the base region, an extension type dummy emitter 32 composed of SiOₓ layer 30 and Al layer 31 extending from the emitter part to the insulation region 13 is formed by the method shown in the embodiment of Fig.6 (Fig. 21 b)). Thereafter, according to the method shown the embodiment of Fig. 7, an extension type emitter projection 9 and an external base region 4c are formed (Fig. 21 (c)), and an umbrella-shaped dummy emitter 32 is converted into an emitter electrode metal layer 10a. By employing this method, since the emitter electrode serves also as emitter draw-out electrode and it is formed by self-alignment corresponding to the emitter part, a bipolar transistor of a very small emitter size can be also fabricated. In this embodiment, although the method of forming an umbrella-shaped electrode metal layer is exhibited, the formation of emitter electrode metal layer as disclosed in the embodiments of Figs. 6,8,9,10 is also applicable.

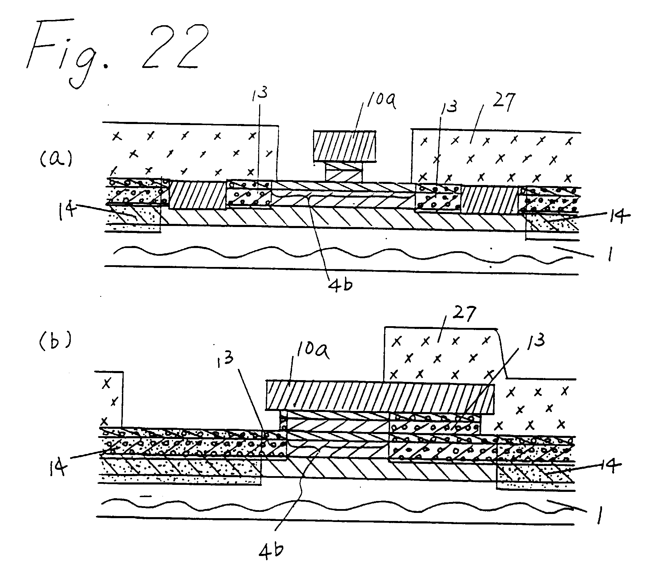

Emb. 22 Fig. 22 shows a method of forming, by self-alignment, a base electrode metal layer 11a serving as both base electrode and base draw-out electrode and existing adjacently to the emitter portion, referring to a case of using an umbrella-shaped electrode metal layer. In the process shown in Fig. 21, after forming an umbrella-shaped electrode metal layer 10a shown in Fig. 1, a collector electrode 12a is formed as shown in Fig. 1, and H⁺ ions are implanted around the transistor. Consequently, an insulating region 14 ranging from the surface to substrate 1 is formed. Then, as shown in Fig. 22, a base electrode 28 is evaporated and lifted off by using a photosensitive resin mask 27 and the umbrella-shaped emitter electrode metal layer 10a as mask. Consequently, in conjunction with the base region 4b just beneath the emitter electrode metal layer 10a, a base electrode metal layer 11a extending from the external base region to the peripheral insulating region 14 is formed. In this embodiment, although the method of Fig. 15 of using umbrella-shaped emitter electrode metal layer is employed, the method of formation of base electrode metal layer as described with reference to Figs. 16, 17, 18, 19, 20 is also applicable.

## Claims

1. A bipolar transistor comprising a first layer (3) including a collector portion (3a), and a second layer (4) formed on said first layer and including a base portion (4a),
wherein said second layer (4) further includes an insulating portion (13) extending from said base portion, and wherein
said bipolar transistor further comprises;
a third layer (5a, 5b), including an emitter portion (5a), formed on a part of said base portion and extending to cover a part of said insulating portion of said second layer; and
an emitter electrode layer (10a) formed to cover an entire upper surface of said third layer wherein a part of said emitter electrode layer on a part of said third layer covering a part of said insulating portion of said second layer serves as an emitter electrode contact lead.

2. A bipolar transistor according to claim 1, wherein said third layer (5a, 5b) is made of a semiconductor material having a wider energy band gap than that of a material of said second layer (4).

3. A bipolar transistor according to claim 1, wherein a part (5b) of said third layer (5a, 5b) on said insulting portion (13) of said second layer (4) is of an insulating material.

4. A bipolar transistor according to claim 1, wherein said base portion (4a) of said second layer (4) adjacent to a part thereof corresponding on a plan view to said emitter electrode layer (10a) has a lower sheet resistance than that of said base portion corresponding on a plan view to said emitter electrode layer.

5. A bipolar transistor according to claim 1, wherein said first layer (3) adjacent to a part thereof corresponding on a plan view to said emitter electrode layer (10a) is of an insulating material.

6. A bipolar transistor according to claim 1, wherein said emitter electrode layer (10a) is wider in width than said third layer (5a, 5b), and wherein a base electrode layer (11a) is formed on said base portion (4a) of said second layer (4) adjacent to a part thereof corresponding on a plan view to said emitter electrode layer (10a), said base electrode layer (11a) being extended to cover a part of said insulating portion (13) of said second layer (4).

7. A bipolar transistor comprising a first layer (3) including an emitter portion (3a), and a second layer (4) formed on said first layer and including a base portion (4a),
wherein said second layer (4) further includes an insulating portion (13) extending from said base portion, and wherein
said bipolar transistor further comprises:
a third layer (5a, 5b), including a collector portion (5a), formed on a part of said base portion and extending to cover a part of said insulating portion of said second layer; and
a collector electrode layer (10a) formed to cover an entire upper surface of said third layer wherein a part of said collector electrode layer on a part of said third layer covering a part of said insulating portion of said second layer serves as a collector electrode contact lead.

8. A bipolar transistor according to claim 7, wherein said third layer (5a, 5b) is made of a semiconductor material having a wider energy band gap than that of a material of said second layer (4).

9. A bipolar transistor according to claim 7, wherein a part (5b) of said third layer (5a, 5b) on said insulating portion (13) of said second layer (4) is of an insulating material.

10. A bipolar transistor according to claim 7, wherein said base portion (4a) of said second layer (4) adjacent to a part thereof corresponding on a plan view to said collector electrode layer (10a) has a lower sheet resistance than that of said base portion corresponding on a plan view to said collector electrode layer.

11. A bipolar transistor according to claim 7, wherein said first layer (3) adjacent to a part thereof corresponding on a plan view to said collector electrode layer (10a ) is of an insulating material.

12. A bipolar transistor according to claim 7, wherein said collector electrode layer (10a) is wider in width than said third layer (5a, 5b), and wherein a base electrode layer (11a) is formed on said base portion (4a) of said second layer (4) adjacent to a part thereof corresponding on a plan view to said collector electrode layer (10a), said base electrode layer (11a) being extended to cover a part of said insulating portion (13) of said second layer (4).

## Patentansprüche

1. Ein bipolarer Transistor, der eine erste Schicht (3), die einen Kollektorbereich (3a) einschließt, und eine zweite Schicht (4) umfaßt, die auf der genannten ersten Schicht gebildet ist und einen Basisbereich (4a) einschließt, worin die genannte zweite Schicht (4) des weiteren einen Isolierbereich (13) einschließt, der sich von dem genannten Basisbereich erstreckt, und worin der genannte bipolare Transistor ferner umfaßt eine dritte Schicht (5a, 5b), die einen Emitterbereich (5a) einschließt, der auf einem Teil des genannten Basisbereiches gebildet ist und sich fortsetzt, einen Teil des genannten Isolierbereiches der genannten zweiten Schicht zu überdecken, und eine Emitterelektrodenschicht (10a), die gebildet ist, eine gesamte obere Oberfläche der genannten dritten Schicht zu überdecken, worin ein Teil der genannten Emitterelektrodenschicht auf einem Teil der genannten dritten Schicht, die einen Teil des genannten Isolierbereiches der genannten zweiten Schicht überdeckt, als eine Emitterelektrodenkontaktleitung dient.

2. Ein bipolarer Transistor, gemäß Anspruch 1, worin die genannte dritte Schicht (5a, 5b) aus einem Halbleitermaterial hergestellt ist, das eine weitere Energiebandlücke als diejenige eines Materials der genannten zweiten Schicht (4) hat.

3. Ein bipolarer Transistor, gemäß Anspruch 1, worin ein Teil (5b) der genannten dritten Schicht (5a, 5b) auf dem genannten Isolierbereich (13) der genannten zweiten Schicht (4) aus einem Isoliermaterial ist.

4. Ein bipolarer Transistor, gemäß Anspruch 1, worin der genannte Basisbereich (4a) der genannten zweiten Schicht (4) nahe einem Teil davon entsprechend in einer Drauficht der genannten Emitterelektrodenschicht (10a) einen geringeren Flächenwiderstand als den des genannten Basisbereihes hat, der in einer Drausicht der genannten Emitterelektrodenschicht entspricht.

5. Ein bipolarer Transistor, gemäß Anspruch 1, worin die genannte erste Schicht (3) nahe einem Teil davon entsprechend in einer Draufsicht der genannten Emitterelektrodenschicht (10a) aus einem Isoliermaterial ist.

6. Ein bipolarer Transistor, gemäß Anspruch 1, worin die genannte Emitterelektrodenschicht (10a) eine größere Weite als die genannte dritte Schicht (5a, 5b) hat und worin eine Basiselektrodenschicht (11a) auf dem genannten Basisbereich (4a) der genannten zweiten Schicht (4) nahe einem Teil davon entsprechend in einer Draufsicht genannten Emitterelektrodenschicht (10a) gebildet ist, wobei die genannte Basiselektrodenschicht (11a) forgesetzt ist, einen Teil des genannten Isolierbereiches (13) der genannten zweiten Schicht (4) zu überdecken.

7. Ein bipolarer Transistor, der eine erste Schicht (3), die einen Emitterbereich (3a) einschließt, und eine zweite Schicht (4) umfaßt, die auf der genannten ersten Schicht gebildet ist und einen Basisbereich (4a) einschließt, worin die genannte zweite Schicht (4) des weiteren einen Isolierbereich (13) einschließt, der sich von dem genannten Basisbereich erstreckt, und worin der genannte bipolare Transistor ferner umfaßt eine dritte Schicht (5a, 5b), die einen Kollektorbereich (5a) einschließt, der auf einem Teil des genannten Basisbereiches gebildet ist und sich fortsetzt, einen Teil des genannten Isolierbereiches der genannten zweiten Schicht zu überdecken, und eine Kollektorelektrodenschicht (10a), die gebildet ist, eine gesamte obere Oberfläche der genannten dritten Schicht zu überdecken, worin ein Teil der genannten Kollektorelektrodenschicht auf einem Teil der genannten dritten Schicht, die einen Teil des genannten Isolierbereiches der genannten zweiten Schicht überdeckt, als eine Kollektorelektrodenkontaktleitung dient.

8. Ein bipolarer Transistor, gemäß Anspruch 1, worin die genannte dritte Schicht (5a, 5b) aus einem Halbleitermaterial hergestellt ist, das eine weitere Energiebandlücke als diejenige eines Materials der genannten zweiten Schicht (4) hat.

9. Ein bipolarer Transistor, gemäß Anspruch 1, worin ein Teil (5b) der genannten dritten Schicht (5a, 5b) auf dem genannten Isolierbereich (13) der genannten zweiten Schicht (4) aus einem Isoliermaterial ist.

10. Ein bipolarer Transistor, gemäß Anspruch 1, worin der genannte Basisbereich (4a) der genannten zweiten Schicht (4) nahe einem Teil davon entsprechend in einer Draufsicht der genannten Kollektorelektrodenschicht (10a) einen geringeren Flächenwiderstand als den des genannten Basisbereiches hat, der in einer Drausicht der genannten Kollektorelektrodenschicht entspricht.

11. Ein bipolarer Transistor, gemäß Anspruch 1, worin die genannte erste Schicht (3) nahe einem Teil davon entsprechend in einer Draufsicht der genannten Kollektorelektrodenschicht (10a) aus einem Isoliermaterial ist.

12. Ein bipolarer Transistor, gemäß Anspruch 1, worin die genannte Kollektorelektrodenschicht (10a) eine größere Weite als die genannte dritte Schicht (5a, 5b) hat und worin eine Basiselektrodenschicht (11a) auf dem genannten Basisbereich (4a) der genannten zweiten Schicht (4) nahe einem Teil davon entsprechend in einer Draufsicht genannten Kollektorelektrodenschicht (10a) gebildet ist, wobei die genannte Basiselektrodenschicht (11a) forgesetzt ist, einen Teil des genannten Isolierbereiches (13) der genannten zweiten Schicht (4) zu überdecken.

## Revendications

1. Transistor bipolaire comprenant une première couche (3) incluant une partie de collecteur (3a), et une seconde couche (4) formée sur ladite première couche et incluant une partie de base (4a), dans lequel:
ladite seconde couche (4) inclut en outre une partie isolante (13) s'étendant depuis ladite partie de base, et dans lequel
ledit transistor bipolaire comprend en outre :
une troisième couche (5a, 5b), incluant une partie d'émetteur (5a), formée sur une partie de ladite partie de base et s'étendant de manière à recouvrir une partie de ladite partie isolante de ladite seconde couche ; et
une couche d'électrode d'émetteur (10a) formée de manière à recouvrir la totalité d'une surface supérieure de ladite troisième couche, où une partie de ladite couche d'électrode d'émetteur sur une partie de ladite troisième couche recouvrant une partie de ladite partie isolante de ladite seconde couche joue le rôle de connexion de contact d'électrode d'émetteur.

2. Transistor bipolaire selon la revendication 1, dans lequel ladite troisième couche (5a, 5b) est réalisée en un matériau semiconducteur présentant une bande interdite plus large que celle d'un matériau de ladite seconde couche (4).

3. Transistor bipolaire selon la revendication 1, dans lequel une partie (5b) de ladite troisième couche (5a, 5b) sur ladite partie isolante (13) de ladite seconde couche (14) est en un matériau isolant.

4. Transistor bipolaire selon la revendication 1, dans lequel ladite partie de base (4a) de ladite seconde couche (4) adjacente à une partie afférente correspondant, selon une vue en plan, à ladite couche d'électrode d'émetteur (10a), présente une valeur de résistance par carré inférieure à celle de ladite partie de base correspondant, selon une vue en plan, à ladite couche d'électrode d'émetteur.

5. Transistor bipolaire selon la revendication 1, dans lequel ladite première couche (3) adjacente à une partie afférente correspondant, selon une vue en plan, à ladite couche d'électrode d'émetteur (10a), est en un matériau isolant.

6. Transistor bipolaire selon la revendication 1, dans lequel ladite couche d'électrode d'émetteur (10a) présente une largeur plus importante que celle de ladite troisième couche (5a, 5b) et dans lequel une couche d'électrode de base (11a) est formée sur ladite partie de base (4a) de ladite seconde couche (4) adjacente à une partie afférente correspondant, selon une vue en plan, à ladite couche d'électrode d'émetteur (10a), ladite couche d'électrode de base (11a) étant étendue de manière à recouvrir une partie de ladite partie isolante (13) de ladite seconde couche (4).

7. Transistor bipolaire comprenant une première couche (3) incluant une partie d'émetteur (3a), et une seconde couche (4) formée sur ladite première couche et incluant une partie de base (4a), dans lequel :
ladite seconde couche (4) inclut en outre une partie isolante (13) s'étendant depuis ladite partie de base, et dans lequel
ledit transistor bipolaire comprend en outre :
une troisième couche (5a, 5b), incluant une partie de collecteur (5a), formée sur une partie de ladite partie de base et s'étendant de manière à recouvrir une partie de ladite partie isolante de ladite seconde couche ; et
une couche d'électrode de collecteur (10a) formée de manière à recouvrir la totalité d'une surface supérieure de ladite troisième couche, où une partie de ladite couche d'électrode de collecteur sur une partie de ladite troisième couche recouvrant une partie de ladite partie isolante de ladite seconde couche joue le rôle de connexion de contact d'électrode de collecteur.

8. Transistor bipolaire selon la revendication 7, dans lequel ladite troisième couche (5a, 5b) est réalisée en un matériau semiconducteur présentant une bande interdite plus large que celle d'un matériau de ladite seconde couche (4).

9. Transistor bipolaire selon la revendication 7, dans lequel une partie (5b) de ladite troisième couche (5a, 5b) sur ladite partie isolante (13) de ladite seconde couche (4) est en un matériau isolant.

10. Transistor bipolaire selon la revendication 7, dans lequel ladite partie de base (4a) de ladite seconde couche (4) adjacente à une partie afférente correspondant, selon une vue en plan, à ladite couche d'électrode de collecteur (10a), présente une valeur de résistance par carré inférieure à celle de ladite partie de base correspondant, selon une vue en plan, à ladite couche d'électrode de collecteur.

11. Transistor bipolaire selon la revendication 7, dans lequel ladite première couche (3) adjacente à une partie afférente correspondant, selon une vue en plan, à ladite couche d'électrode de collecteur (10a), est en un matériau isolant.

12. Transistor bipolaire selon la revendication 7, dans lequel ladite couche d'électrode de collecteur (10a) présente une largeur plus importante que celle de ladite troisième couche (5a, 5b) et dans lequel une couche d'électrode de base (11a) est formée sur ladite partie de base (4a) de ladite'seconde couche (4) adjacente à une partie afférente correspondant, selon une vue en plan, à ladite couche d'électrode de collecteur (10a), ladite couche d'électrode de base (11a) étant étendue de manière à recouvrir une partie de ladite partie isolante (13) de ladite seconde couche (4).
